Europäisches Patentamt

(19) European Patent Office

Office européen des brevets

(11) Publication number: **0 164 747**
**A2**

(12) # EUROPEAN PATENT APPLICATION

(21) Application number: **85107269.4**

(22) Date of filing: **12.06.85**

(51) Int. Cl.⁴: **H 03 M 1/38**

(30) Priority: **13.06.84 US 620232**

(43) Date of publication of application:
**18.12.85 Bulletin 85/51**

(84) Designated Contracting States:
**DE FR GB NL**

(71) Applicant: **TEKTRONIX, INC.**
**Tektronix Industrial Park D/S Y3-121 4900 S.W. Griffith Drive P.O. Box 500**
**Beaverton Oregon 97077(US)**

(72) Inventor: **Davidson, Scott A.**
**14205 S.W. Jenkins Road, No. 28**
**Beaverton Oregon 97005(US)**

(74) Representative: **Weickmann, Heinrich, Dipl.-Ing. et al,**
**Patentanwälte Dipl.-Ing. H.Weickmann Dipl.-Phys.Dr. K.Fincke Dipl.-Ing. F.A.Weickmann Dipl.-Chem. B. Huber Dr.-Ing. H. Liska Dipl.-Phys.Dr. J. Prechtel Möhlstrasse 22 D-8000 München 80(DE)**

(54) Successive approximation adc with variable frequency clock.

(57) A successive approximation analog-to-digital converter is used in a synchronization system for matching the audio portion of an audio-visual signal with the video portion which is subject to inherent delays for signal processing. The ADC includes a successive approximation register clocked by a variable frequency clock, the frequency generally increasing as the register moves from most to least significant digit of the output digital word to maximize the speed of the conversion process.

FIG.I

EP 0 164 747 A2

# SUCCESSIVE APPROXIMATION ADC WITH
## VARIABLE FREQUENCY CLOCK

### BACKGROUND OF THE INVENTION

The present invention relates to a means for converting analog signals to digital signals and more particularly for optimizing the speed of such of conversions in a way that avoids high-cost logic components.

Analog-to-digital converters are frequently used in applications which call for a delay of an analog electrical signal. For example, in television systems it is frequently necessary to delay the audio portion of a composite audio-visual signal to compensate for various delays in the video portion of the signal which are occasioned by signal processing and/or signal enhancement requirements. Usually the types of processing/enhancement circuits required for video are not required for audio, and absent some means for delaying the audio signal, there would be no means for correlating the audio with the video portion of the composite signal. A common technique used in the past has been to convert the audio, which is essentially an analog signal, to a digital signal and delay the signal with a digital delay line. Digital delay lines are particularly desirable for this purpose as they are inherently more accurate than analog-type delay lines.

Problems may arise, however, in converting the analog audio signal into a digital format. For example, the analog-to-digital (A/D) conversion process may be too slow for proper correlation with a video signal that has little inherent delay. Very fast A/D conversion may be obtained such as with ECL logic components, but these are relatively expensive.

There exist commercially-available analog-to-digital converters which use a successive approximation method for converting an analog to a digital signal. The successive approximation A/D converters utilize a special-purpose shift register which contains the digital logic necessary to effect the A/D conversion. These operate on a sampled and held portion of an analog signal. For each portion of the analog signal sampled, the successive approximation A/D converter completes a series of approximation cycles driven by clock pulses in which each cycle determines a bit of binary resolution for the digital value representing the analog signal. Depending upon the number of bits of resolution required, there will be "n" number of clock cycles to derive a digital value from the sampled analog signal.

Successive approximation A/D converters are closed loop systems, however, having inherent propagation and settling delays. The largest of these delays is caused by a digital-to-analog converter (DAC) which converts a digital approximation of the sampled analog signal to a second analog signal for successive comparisons with the sampled analog signal.

The heart of this type of A/D converter is a successive approximation register (SAR) which begins each series of cycles at a specified initial value for the digital word and toggles that word one bit during each clock cycle beginning with most significant digit. The resulting digital approximation is converted to an analog signal in the DAC and compared to the sampled analog signal. Depending upon whether the DAC output is higher or lower than the sampled analog signal, the SAR updates the digital word for that particular bit of resolution. Since the SAR begins with the most significant digit, the widest swings in the output of the DAC occur during this first clock cycle.

The DAC usually includes an output voltage amplifier which has a slew rate that is slow compared to the remaining components in the circuit. The slew rate of the output amplifier is, thus, the primary limiting factor in the speed of this type of A/D converter. The slew rate, however, is less of a limitation on bits of lesser significance in the digital word, because the analog voltage representative of these bits is progressively less than that required for the most significant bit in the digital word. However, the clock which controls each of the N number of cycles during each sampling period must provide the time required for the output voltage amplifier to rise to the maximum output needed for the most significant bit. This time may also be thought of as the loop settling time.

## SUMMARY OF THE INVENTION

The present invention addresses the problem of the inherent limitations of a successive approximation analog-to-digital converter by varying the clock frequency as a function of the time required for the loop voltage to rise to the level required, i.e. to a steady state value. This time is a function of the slew rate of the voltage output amplifier multiplied by the amplitude of the voltage swing required to approximate the "nth" significant digit of the digital word. The present invention solves the above-mentioned problem and provides a faster analog-to-digital conversion by periodically adjusting the frequency of the clock during the sampling period.

The analog-to-digital converter of the present invention comprises an SAR loop driven by a variable frequency clock. The loop consists of an analog comparator having an input from a sample and hold circuit for sampling the analog signal. The other input to the comparator is the output of a digital-to-analog converter which consists of a current DAC and an output voltage amplifier. Analog-to-digital conversion is controlled by an SAR. The SAR supplies the current DAC with an initial predetermined digital word which is assumed to lie at approximately the midpoint of the analog values expected to be encountered. The current DAC converts the digital word to an analog current which, in turn, is converted to an analog voltage by the voltage amplifier. This voltage is compared to the sampled and held analog voltage and an output is produced.

The output of the comparator is either "high" or "low" depending upon whether the sampled voltage is higher or lower than loop voltage. The comparator output then toggles the SAR by one digit, updating the digital word to approximate the value of the analog voltage for each "nth" bit of binary resolution. This digital value is, in turn, converted to an analog voltage and the process is repeated for the next decreasingly significant bit of binary information. When "n" repetitions of this cycle have been completed, the conversion process is complete to the "nth" significant digit. This process is repeated for each analog data sample.

The SAR responds to a clock which generates "n" cycles of clock pulses per sampling period. The frequency of the clock pulses may be, according to the invention, adjusted to compensate for differences in the loop settling time which is in part a function of the voltage amplifier's slew rate times the voltage swing required for the "nth" significant digit. In addition to slew rate limiting, the overall loop settling time is also a function of the transient behavior of the loop after the voltage rises to the level required. After a rapid voltage rise, the loop may oscillate or ring before settling out to a steady state value. For example, since the successive approximation register proceeds from the most significant to the least significant digit, the largest voltage swings will occur on the first approximation.

The clock must enable the SAR for as long as required for the loop voltage to rise to and settle upon its steady state value. Since the next successive approximation, however, will be a less significant digit, the voltage swing will not be as large and, therefore, the loop settling time will be smaller. In order to increase the speed of the conversion process, the frequency of the clock may be adjusted so that the SAR is enabled for a shorter period of time when voltage swings of lesser magnitude are expected. The loop settling times become progressively shorter as the SAR proceeds from most significant to least significant digit. Thus each output cycle of the clock needs to have a pulse width only sufficiently long to ensure that the loop voltage has settled to its steady-state value as demanded by the "nth" significant digit of the digital word. In other words, as the output swing of the DAC and voltage amplifier decreases, the clock frequency increases. In this way the speed of the loop is maximized for each sampling period.

A principal object of this invention is to provide analog-to-digital conversion for an electrical signal which is fast and accurate.

A further object of this invention is to provide fast analog-to-digital conversion using relatively inexpensive components.

A still further object of this invention is to provide analog-to-digital conversion using a successive approximation loop driven by a variable frequency clock to make most efficient use of the successive approximation technique.

The foregoing and other objectives, features, and advantages of the present invention will be more readily understood upon consideration of the following 35 detailed description of the invention, taken in conjunction with the accompanying drawings.

## BRIEF DESCRIPTION OF THE DRAWINGS

FIG. 1 is a block diagram of a television signal processing system incorporating the analog-to-digital converter of the present invention.

FIG. 2 is a detailed block diagram of the analog-to-digital converter used in the audio channel of the system illustrated in FIG. 1.

FIG. 3 is a wave form diagram illustrating the principle of operation of the analog-to-digital converter shown in FIG. 2.

## DETAILED DESCRIPTION OF THE INVENTION

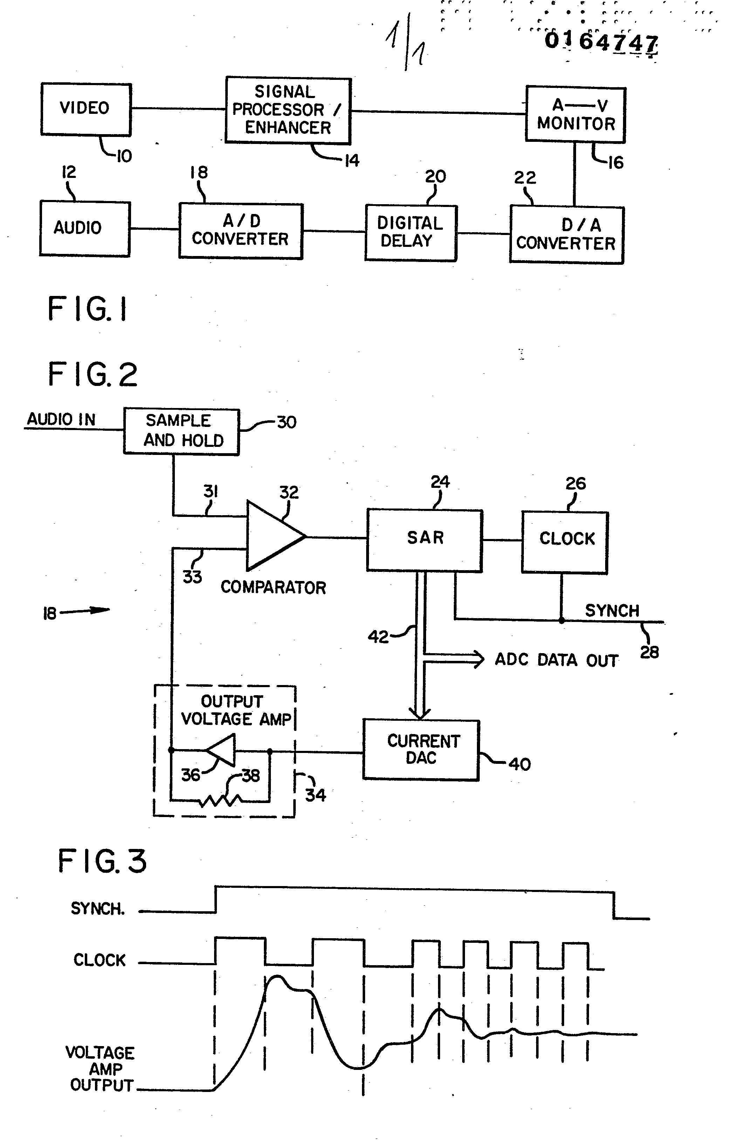

Referring to FIG. 1 a television system utilizing the A/D converter of the present invention is shown. The system comprises a video channel 10 and an audio channel 12. The video channel signal is subject to various signal processing and/or signal enhancement circuits shown schematically at 14. A necessary result of the use of circuits 14 is an inherent delay of the video signal before it can be displayed on audio-visual monitor 16. In order to match these inherent delays, a delay line is provided for in the audio channel 12. This delay line comprises an A/D converter 18 connected to a digital delay device 20, the output of which is reconverted to an analog audio signal in digital-to-analog converter 22. In order to provide maximum accuracy for the system, it is desirable that the analog-to-digital converter 18 and the digital-to-analog converter 22 be made to operate with a maximum conversion rate.

FIG. 2 shows the preferred form of the analog-to-digital converter 18 for use in the system of FIG. 1. This A/D converter is a successive approximation type, and as such includes a successive approximation shift register 24. Successive approximation register (SAR) 24 is connected to clock 26. The initiation of the operation of both SAR 24 and clock 26 is controlled by synchronization line 28 which is connected to an appropriate sync generator (not shown). The audio output of audio generator 12 is connected to input of sample-and-hold circuit 30 and the output of the sample-and-hold circuit is connected to one of two inputs of comparator 32. The other input to comparator 32 is the output of output voltage amp 34. As is conventional, output voltage amp 34 comprises operational amplifier 36 and a shunt resistor 38. The output voltage amplifier 36 has an input which is connected to the output of a current digital-to-analog converter (DAC) 40. The output line 42 of the successive approximation register is the digital data output which is connected to digital delay device 20 and also drives current DAC 40 in order to complete a closed loop system.

In actual operation, the output of audio amplifier 12 is periodically sampled and held at a predetermined sampling rate by sample-and-hold circuit 30. Initiation of a sampling period turns on clock 26 which begins to cycle through a program of clock pulses having predetermined pulse widths. The number of clock pulses during each cycle depends upon the number of bits of binary resolution required for each analog-to-digital conversion during a sampling period. The result is that at the end of a sampling period, digital delay device 20 has accumulated a digital word expressed in binary form having "n" bits of binary resolution. This digital word is representative of the analog value sampled by sample-and-hold circuit 30 during a particular sampling period.

The SAR begins each sampling period with its digital output word at a specified initial value. This initial value is converted to an analog voltage by current DAC 40 and output voltage amplifier 34 and appears as an input to comparator 32 on line 33. The sampled and held voltage from the audio generator 12 appears also as an input to comparator 32 on line 31.

The output of comparator 32 is either "high" or "low" depending upon whether the voltage on line 33 is higher or lower than the voltage on line 31. The high/low output of comparator 32 causes the successive approximation register to update the preprogrammed digital word one bit at a time depending upon the comparator output. For example, if the comparator output is high and the present value of the digital word for that bit is a "zero", the zero is replaced with a one. This cycle repeats itself "n" number of times where "n" is the number of bits of binary resolution required. In essence, the loop formed by SAR 24, current DAC 40, output voltage amp 34 and comparator 32 successively "guesses" the value of the analog voltage on line 31. In response to the result of each successive "guess," a digital word is derived which represents, in digital format, the analog voltage held in sample-and-hold circuit 30.

Since the loop is a closed loop system, and further since this system involves a conversion of a digital word to an analog voltage, there is a finite response time for the loop voltage to settle to a steady-state value for each successive approximation. The primary limiting factor in the speed of the loop is the slew rate of the output voltage amplifier 34. Thus, the settling time for the loop can never be faster than the slew rate times the voltage swing required by the value of the output of the current DAC 40. This voltage swing will be larger for the more significant bits in the binary word. The loop completes one bit of approximation per clock pulse and should settle to a steady-state value before the next clock pulse begins. Therefore, the width of the pulses from clock 26 must be at least long enough to accommodate the loop settling time for the largest output voltage swings required of output voltage amplifier 34.

As the successive approximations progress, however, from most significant to least significant bit, these voltage swings decrease in magnitude. The clock is therefore programmed to decrease the width of the clock pulses as the SAR progresses from most to least significant bit. Ideally the frequency of the clock should vary inversely with the overall loop settling time which comprises the slew rate times the voltage swing of amplifier 34 plus the loop transient settling time. In practice, however, it has been discovered that dividing the clock pulses into as few as two groups of pulses having different pulse widths will suffice. This principle is illustrated in FIG. 3. In FIG. 3 a pulse on synchronization line 28 initiates a programmed series of clock pulses from clock 26. The clock pulses fall into two groups, the first two pulses having double the frequency of the last four pulses. As the voltage amplifier output curve shows, the amplifier output must rise to its maximum value on the first pulse. On the second pulse the voltage swing is half as large in terms of absolute value. On successive pulses the voltage swings required are much smaller because less significant bits of the digital word are being approximated. In other words the "guesses" which form the output of output voltage amp 34 move closer and closer to the true analog value on line 31. The graph of FIG. 3 is intended to show the probable shape of a curve for the output voltage amplifier 34 over a sampling period in which the sampled analog value is approximately half of its expected full-scale value. These wave forms are exemplary only, as it should be noted that the clock output may be adjusted to any combination of decreasing pulse widths from most significant to least significant binary bit. However, there will always be at least two pulses in each cycle in which one pulse width will be longer than the next succeeding pulse width to accommodate for the differences in loop settling time and thus allow the loop to operate faster on bits of lesser significance.

Implementation of the clock may be by several methods. For example the clock may take the form of a voltage-controlled oscillator controlled by a voltage ramp. In another embodiment, the clock could be implemented by an N state divider having successive states separated by fewer and fewer states. Still a third method would be to use a Programmable Read Only Memory (PROM) controlled by a counter, where the clock pulses are the output of the PROM.

The terms and expressions which have been employed in the foregoing specification are used therein as terms of description and not of limitation, and there is no intention, in the use of such terms and expressions, of excluding equivalents of the features shown and described or portions thereof, it being recognized that the scope of the invention is defined and limited only by the claims which follow.

I CLAIM:

1. In an audio system having an audio channel for providing an audio signal, the combination comprising:

    (a) an analog-to-digital converter for said audio channel having successive approximation register means for approximating in binary form a digital value for said audio signal, said converter including selectively enabled variable frequency clock means for actuating said register means, wherein the frequency of said clock varies from a lower to a higher frequency during at least part of the time that said clock is enabled; and

    (b) digital delay means connected to the output of said converter means for delaying said digital value a predetermined period of time said period selected so as to substantially synchronize said audio channel with said video channel.

2. The combination of claim 1 wherein said converter comprises a closed loop having a settling time and the output of said clock means comprises a series of pulses, the frequency of at least some of said pulses being inversely related to said settling time.

3. The combination of claim 2 wherein the frequency of all of said pulses are inversely related to said settling time.

4. An analog-to-digital converter comprising:

(a) means for sampling a first signal;

(b) means for comparing said first signal with a second signal which represents an approximation of said first signal to produce an output;

(c) means responsive to said output for successively approximating in digital format the value of said first signal, said successive approximation occurring sequentially in response to each one of a series of clock pulses, each pulse in said series having a predetermined pulse width;

(d) means for converting said digitally-formatted value into said second signal; and

(e) clock means for providing said series of pulses wherein at least one of said pulses in said series has a pulse width longer than the next succeeding pulse in said series.

5. The combination as claimed in claim 4 wherein each of said pulses in said cycle has a pulse width shorter than the preceding pulse.

6. An analog-to-digital converter comprising:

(a) means for sampling an analog signal;

(b) closed loop approximation means responsive to a series of clock pulses for deriving, during successive increments of time, a digital signal representative of said analog signal, said closed loop means having a finite settling time for each successive increment; and

(c) clock means for generating said cycle of pulses wherein at least two of said pulses have pulse widths that approximate the settling time of said loop during the increments of time in which said two pulses are generated, respectively.

7. The combination as claimed in claim 6 in which each clock pulse has a frequency which varies inversely with the settling time of said closed loop during each respective increment of time.

8. The combination of claim 6 wherein said closed loop approximation means includes digital-to-analog converter means for converting said digital signal to an analog signal comparator means responsive to both said analog signal and said sampled analog signal.

9. The combination of claim 8 wherein said digital-to-analog conversion means includes an output voltage amplifier.

10. An analog-to-digital converter comprising:

(a) means for sampling an analog signal;

(b) means for approximating in digital format the value of said analog signal in response to an output from a comparator, said comparator having two inputs, one of said inputs connected to the output of said sampling means;

(c) means for converting said digitally-formatted signal into an analog output signal, said means connected to a second input of said comparator thereby to form

0

64747

-14-

a closed loop, said closed loop having a finite settling time; and

(d) variable frequency clock means for actuating said approximating means, said clock means producing a cycle of clock pulses wherein at least two pulses in each cycle have differing pulse widths, said pulse widths adapted to compensate for differing settling times within said closed loop such that said pulse widths are relatively long for long settling times and relatively short for short settling times.

11. A method of converting an analog signal to a digital signal comprising the steps of:

(a) sampling and holding the analog signal;

(b) comparing the sampled analog signal with a predetermined analog signal to produce an output indicative of whether the second analog signal is higher or lower than the sampled analog signal;

(c) successively approximating a digital value representative of said sampled analog signal in response to the output of said comparison step;

(d) converting the digital approximation of said sampled analog signal into a second analog signal which replaces said predetermined analog signal; and

(e) repeating steps (b)-(d) "n" number of times, each of such repetitions occurring over predetermined periods of time where "n" is a predetermined number of binary bits of resolution and where the length of said periods during at least two of said "n" repetitions decrease one with respect to the other.

12. The method of claim 11 wherein the length of said periods decreases from each pulse to the next succeeding pulse.

## FIG.1

VIDEO — 10 → SIGNAL PROCESSOR / ENHANCER — 14 → A—V MONITOR — 16

AUDIO — 12 → A/D CONVERTER — 18 → DIGITAL DELAY — 20 → D/A CONVERTER — 22

## FIG.2

AUDIO IN → SAMPLE AND HOLD — 30

31 → COMPARATOR 32 → SAR 24 → CLOCK 26

33

18 →

SYNCH — 28

42 → ADC DATA OUT

OUTPUT VOLTAGE AMP — 34
36 — 38

CURRENT DAC — 40

## FIG.3

SYNCH.

CLOCK

VOLTAGE AMP OUTPUT